# FASCICULE DE BREVET EUROPEEN

(11) **EP 1 786 950 B1**
(45) Date de publication et mention de la délivrance du brevet: **25.05.2011**
(21) Numéro de dépôt: 05796061.9
(22) Date de dépôt: 05.08.2005
(51) Int. Cl.: C23C 16/52

(54) **DISPOSITIF D'INTRODUCTION DANS UNE ENCEINTE DE PRECURSEURS LIQUIDES EN MODE PULSE AVEC MESURE ET CONTROLE DU DEBIT**
VORRICHTUNG ZUM EINTRAGEN VON VORLÄUFERN IN EINE KAMMER IN GEPULSTEM MODUS MIT MESSUNG UND REGELUNG DER STRÖMUNGSRATE
DEVICE FOR INTRODUCING PRECURSORS INTO AN ENCLOSURE, IN A PULSED MODE WITH MEASUREMENT AND CONTROL OF THE FLOW RATE

(30) Priorité: 06.08.2004 FR 0408704
(43) Date de publication de la demande: 23.05.2007
(73) Titulaire: Qualiflow-Therm, 34935 Montpellier (FR)
(72) Inventeur: POIGNANT, Frédéric, F-34570 Pignan (FR); BONNAFOUS, Samuel, F-34070 Montpellier (FR); DECAMS, Jean-Manuel, F-34000 Montpellier (FR); GUILLON, Hervé, F-34090 Montpellier (FR)
(74) Mandataire: Hecké, Gérard
(86) Numéro de dépôt international: PCT/FR2005/002049
(87) Numéro de publication internationale: WO 2006/021670

(56) Documents cités:
- WO-A-95/02711
- WO-A-98/10116
- DE-A1- 3 222 425
- US-A- 4 735 225
- US-A- 5 620 524
- US-B1- 6 176 930
- PATENT ABSTRACTS OF JAPAN vol. 017, no. 654 (P-1653), 3 décembre 1993 (1993-12-03) & JP 05 215738 A (SHIMADZU CORP), 24 août 1993 (1993-08-24)
- PATENT ABSTRACTS OF JAPAN vol. 010, no. 387 (P-530), 25 décembre 1986 (1986-12-25) & JP 61 175565 A (SHIMADZU CORP), 7 août 1986 (1986-08-07)

## Description

### Domaine technique de l'invention

L'invention concerne un dispositif d'introduction dans une enceinte d'au moins un précurseur liquide ou en solution d'un élément à déposer sur un support disposé dans l'enceinte, ledit dispositif comportant :
- au moins un réservoir contenant le précurseur,
- des moyens pour maintenir le réservoir à une pression plus élevée que celle de l'enceinte,
- au moins un injecteur connecté au réservoir,
- un circuit de commande comportant des sorties connectées respectivement au réservoir et à l'injecteur pour contrôler ladite pression et/ou le temps d'injection et/ou la fréquence d'injection de manière à injecter périodiquement, dans l'enceinte des gouttelettes de précurseur.

### État de la technique

Dans le domaine des dépôts chimiques en phase vapeur (CVD, avec débits de gaz continus ou pulsés ou avec une combinaison de débits de gaz pulsés et continus) ou des dépôts par couche atomique (ALD), les dispositifs d'introduction, dans la chambre de dépôt, des éléments à déposer ou des précurseurs desdits éléments sont, de plus en plus, constitués par des dispositifs d'injection de gouttelettes liquides. Les gouttelettes liquides sont injectées, soit directement dans la chambre de dépôt, soit dans une enceinte thermostatée couplée à la chambre de dépôt.

De tels dispositifs d'injection permettent de former un spray constitué de fines gouttelettes s'évaporant sans que le précurseur ou l'élément à déposer ne soit, au préalable, entré en contact avec l'enceinte thermostatée ou avec la chambre de réaction. Ceci limite les risques d'encrassement et la génération de particules. Ces dispositifs permettent également d'utiliser de nouveaux types de précurseurs, par exemple des éléments organo-métalliques, liquides ou solides, éventuellement peu volatiles et souvent difficiles à mettre en oeuvre car ils sont, par nature, instables chimiquement ou thermiquement. Ces précurseurs peuvent être utilisés purs, lorsqu'ils sont sous forme liquide, ou bien dissous dans un solvant lorsqu'ils sont sous forme liquide ou solide. Ainsi, de nouveaux matériaux, dont les éléments constitutifs sont, par exemple, des métaux de transition, des alcalino-terreux ou des lanthanides, peuvent être obtenus par dépôt CVD et/ou ALD.

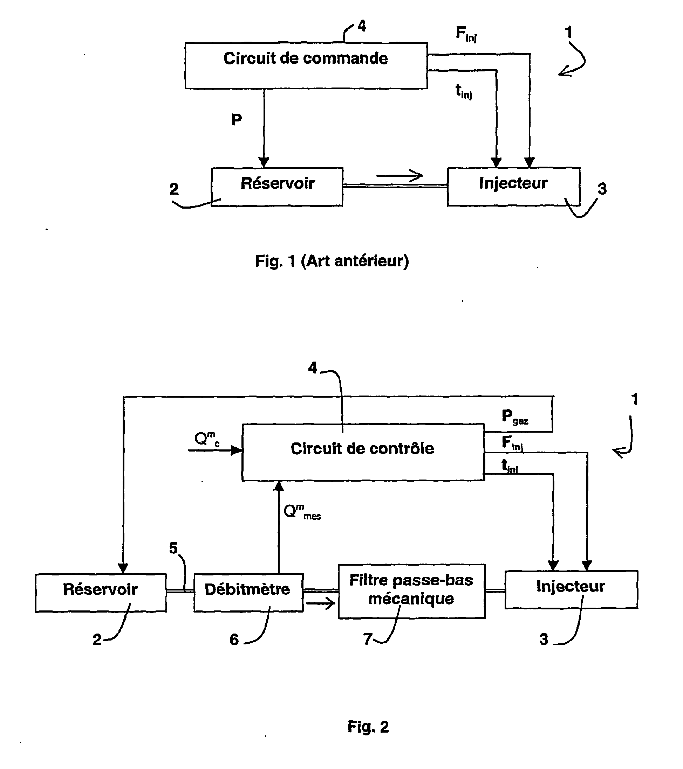

La demande de brevet EP-A-0730671 décrit, par exemple, un dispositif d'introduction de précurseur d'éléments à déposer sur un substrat, dans une enceinte de dépôt CVD par injection discontinue de gouttelettes. Comme représenté à la figure 1, le dispositif d'introduction 1 comporte un réservoir 2 contenant un précurseur sous forme liquide ou en solution et connecté à un injecteur 3. Le dispositif d'introduction 1 comporte également des moyens pour maintenir le réservoir 2 à une pression plus élevée que celle de l'enceinte, la pression P dans le réservoir étant par exemple maintenue par l'introduction, dans la partie supérieure, du réservoir 2 d'un gaz sous pression, et plus particulièrement à une pression prédéterminée P_{gaz} également appelée pression de poussée. L'injection est commandée par un circuit de commande 4 permettant d'injecter périodiquement, dans l'enceinte de dépôt, des gouttelettes de volume déterminé du précurseur, en agissant sur le temps d'ouverture de l'injecteur tᵢₙⱼ, sur la fréquence d'injection Fᵢₙⱼ ou sur la pression du gaz P.

De tels dispositifs fonctionnent en boucle ouverte. Ainsi, pour des conditions expérimentales données, telles que la nature du précurseur, la température de l'enceinte, la température du liquide à injecter, la pression de poussée, l'injecteur 3 est, par exemple, commandé de façon à s'ouvrir périodiquement, c'est-à-dire à une certaine fréquence Fᵢₙⱼ avec un temps d'ouverture tᵢₙⱼ préalablement fixé, de manière à obtenir des gouttelettes de volume déterminé. A la sortie de l'injecteur 3, le liquide est alors pulsé à la fréquence de commande Fᵢₙⱼ.

Le niveau de reproductibilité de tels dispositifs dépend, cependant, fortement de la stabilité des conditions expérimentales telles que la température, la pression de poussée, la pression dans l'enceinte. Il dépend également de la reproductibilité de fonctionnement de l'injecteur 3, lui-même dépendant de sa température, du niveau d'encrassement de la conduite disposée entre le réservoir 2 et l'injecteur 3 ou de la tête d'injection... Par ailleurs, dans certains cas, on observe expérimentalement que le débit moyen de liquide peut varier de plusieurs pour-cent sur quelques dizaines de minutes sans que les paramètres de commande d'injection aient été modifiés.

Par ailleurs le document US a 176 930 décrit aussi un dispositif d'introduction dans une enceinte d'au moins un précurseur liquide ou en solution un réservoir contenant le précurseur, des moyens pour maintenir le réservoir à une pression plus élevée que celle de l'enceinte, un Injecteur connecté au réservoir, un circuit de commande comportant une sortie connectée à l'injecteur pour contrôler le temps d'injection (t) et/ou la fréquence d'injection (F1), un dispositif de mesure de débit disposé entre le réservoir et l'injecteur, un filtre passe - bas mécanique ayant une fonction de transfert (H1) prédéterminée et disposé entre le dispositif de mesure du débit et l'injecteur, et un circuit de commande qui comporte une entrée connectée à la sortie du dispositif de mesure de débit.

### Objet de l'invention

L'invention a pour but d'obtenir un dispositif d'introduction, dans une enceinte, d'au moins un précurseur liquide ou en solution d'un élément à déposer sur un support disposé dans l'enceinte, remédiant aux inconvénients mentionnés ci-dessus et, étant, plus particulièrement, fiable et reproductible.

Selon l'invention, ce but est atteint par le fait que le dispositif comporte :
- un dispositif de mesure de débit moyen, disposé entre le réservoir et l'injecteur,
- et un filtre passe-bas mécanique ayant une fonction de transfert prédéterminée et disposé entre le dispositif de mesure du débit et l'injecteur,
et par le fait que le circuit de commande comporte une entrée de régulation connectée à la sortie du dispositif de mesure de débit moyen, de manière à contrôler ladite pression et/ou le temps d'injection et/ou la fréquence d'injection afin de conserver le débit moyen à une valeur de consigne prédéterminée.

Selon un premier développement de l'invention, un filtre passe-bas mécanique supplémentaire est disposé entre le réservoir et le dispositif de mesure du débit.

Selon un second développement de l'invention, le filtre passe-bas mécanique est constitué par un amortisseur de pulsation.

Selon un autre développement de l'invention, le filtre passe-bas mécanique est une restriction constituée par une portion d'une conduite disposée entre le réservoir et l'injecteur, ladite portion ayant une section transversale inférieure à celle du reste de la conduite de manière à former un étranglement.

Selon un autre développement de l'invention, le filtre passe-bas mécanique est constitué par un raccord destiné à former un volume tampon.

Selon un mode de réalisation préférentiel, le circuit de commande comporte un circuit de correction connecté à l'entrée de régulation et tenant compte de la fonction de transfert du filtre passe-bas mécanique.

Selon un autre mode particulier de réalisation, le dispositif comporte un circuit de régulation de la pression comportant au moins des première et seconde entrées respectivement connectées à la sortie du circuit de commande associée au réservoir et à un dispositif de mesure de la pression dans le réservoir.

Selon une autre caractéristique, le circuit de régulation de la pression comporte au moins des première et seconde sorties, respectivement connectées à une vanne d'entrée et à une vanne de sortie, contrôlant respectivement l'introduction et l'évacuation d'un gaz comprimé dans le réservoir.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente sous forme de schéma-blocs un dispositif d'introduction de précurseurs selon l'art antérieur
La figure 2 représente sous forme de schéma-blocs un dispositif d'introduction de précurseurs selon l'invention.
Les figures 3 et 4 illustrent respectivement des variations de débits instantané et moyen en fonction du temps, dans un dispositif selon l'art antérieur et dans un dispositif selon l'invention.
La figure 5 représente schématiquement un mode particulier de réalisation d'un dispositif selon l'invention.
La figure 6 illustre des variations de débits instantané et moyen en fonction du temps, dans un dispositif selon l'invention, lors d'un changement de fréquence d'injection.
La figure 7 représente schématiquement un mode particulier de réalisation des moyens de régulation de la pression dans le réservoir d'un dispositif selon l'invention.
La figure 8 représente schématiquement une variation du mode particulier d'un dispositif selon la figure 2.

### Description de modes particuliers de réalisation

Selon l'invention, l'injection périodique, dans une enceinte telle qu'une chambre de dépôt CVD ou ALD ou une chambre thermostatée couplée à ladite chambre de dépôt, d'au moins un précurseur liquide ou en solution d'un élément à déposer sur un support disposé dans l'enceinte est obtenu par un dispositif d'introduction 1 tel que celui représenté à la figure 2. Le dispositif d'introduction 1 comporte un réservoir 2 connecté à un injecteur 3, par l'intermédiaire d'une conduite 5 destinée à alimenter l'injecteur en précurseur. Le réservoir 2 contenant le précurseur est maintenu, par tout type de moyens, à une pression P plus élevée que celle de l'enceinte dans laquelle est injecté le précurseur. La pression P dans le réservoir 2 est, par exemple, maintenue plus élevée que celle de l'enceinte, par l'introduction contrôlée d'un gaz comprimé dans le réservoir 2. La pression à laquelle est injecté le gaz comprimé dans le réservoir 2 est également appelée pression de poussée P_{gaz}.

Un dispositif de mesure de débit ou débitmètre 6 est disposé entre le réservoir 2 et l'injecteur 3, de manière à mesurer le débit moyen (Q^{m}ₘₑₛ), en amont de l'injecteur 3. Le débitmètre 6 est, par exemple, un débitmètre liquide massique tel qu'un débitmètre à effet Coriolis ou un débitmètre thermique, ou bien un débitmètre liquide volumique, à lecture instantanée, ou bien encore un débitmètre basé sur une mesure de différence de pression aux bornes d'une restriction dans laquelle s'écoule le précurseur liquide.

Or, actuellement, de tels débitmètres ne sont pas adaptés aux fréquences d'injection utilisées. Ainsi, pour une fréquence d'injection relativement faible, par exemple 5Hz, le signal du débitmètre et la pression en amont de celui-ci sont pulsés à la fréquence d'injection. Dans ces conditions, même avec un système de régulation de la pression, le signal mesuré par le débitmètre oscille fortement et risque de dépasser la valeur maximale prédéterminée de mesure et de s'éloigner du domaine de linéarité du débitmètre. Dans ce cas, la valeur moyenne du débit mesuré n'est plus représentative du débit moyen dans la conduite 5. Par ailleurs, le comportement des dispositifs d'injection périodique, en mode pulsé de précurseurs liquides ou en solution, et plus particulièrement la variation du débit moyen de liquide à injecter d'un dépôt à l'autre (reproductibilité), ne peut pas être anticipé et corrigé. Il est, généralement, mis en évidence indirectement et a posteriori en analysant, par exemple, l'épaisseur des couches minces obtenues par dépôt CVD ou ALD. De même, pour ces systèmes, la variation du débit moyen de liquide à injecter au cours d'un dépôt (répétabilité) ne peut pas être anticipée ou corrigée et ne peut être mise en évidence qu'a posteriori en analysant, par exemple, dans le cas de dépôts de matériaux multimétalliques obtenus à partir de précurseurs homométalliques injectés, dans l'enceinte, par des lignes d'injection distinctes, la stabilité de la composition de la couche dans son épaisseur.

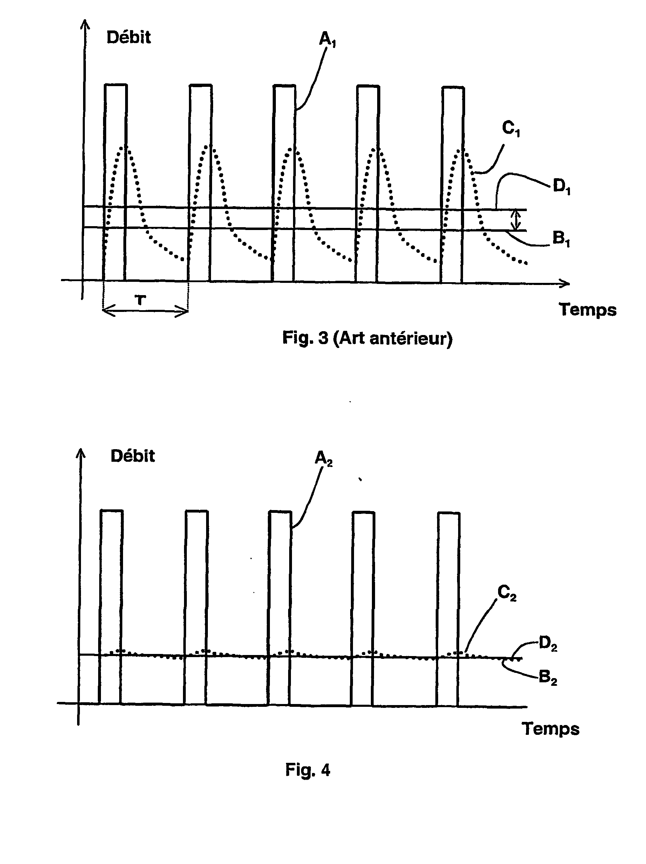

A titre d'illustration, la figure 3 représente des variations de débit en fonction du temps d'un dispositif d'injection tel que celui représenté à la figure 1, avec un débitmètre disposé entre le réservoir 2 et l'injecteur 3. Les courbes A₁ à D₁ représentent respectivement la variation, en fonction du temps :
- du débit instantané au niveau de l'injecteur (A₁),
- du débit moyen au niveau de l'injecteur sur une période d'injection T (B₁),
- du débit instantané mesuré par le débitmètre (C₁)
- et du débit mesuré par le débitmètre et intégré sur une période d'injection T (D₁).

La courbe A₁ est constituée d'une succession d'impulsions rectangulaires de période prédéterminée tandis que la courbe C₁, en pointillé, est constituée d'une succession d'impulsions sensiblement amorties par la présence du débitmètre. Les courbes B₁, et D₁ correspondent respectivement à des valeurs moyennes sensiblement constantes dans le temps, mais différentes l'une de l'autre. Ceci illustre, ainsi, la difficulté, avec des dispositifs d'injection périodique, de mesurer correctement le débit moyen, même lorsque celui-ci est intégré sur une période d'injection.

Comme représenté à la figure 2, le dispositif d'introduction 1 comporte, en outre, un filtre passe-bas mécanique 7, avec une fonction de transfert H₁ connue. Le filtre passe-bas mécanique est disposé entre le débitmètre 6 et l'injecteur 3 et.a pour fonction de transformer le débit instantané au niveau de l'injecteur 3, c'est-à-dire en aval du filtre passe-bas, en un débit moyen sensiblement constant au niveau du débitmètre 6, c'est-à-dire en amont du filtre passe-bas. Ceci permet d'obtenir une mesure fiable du débit moyen au niveau du débitmètre 6, comme illustré à la figure 4 sur laquelle sont représentées des variations de débit en fonction du temps d'un dispositif d'injection tel que celui représenté à la figure 2. Les courbes A₂ à D₂ représentent respectivement la variation, en fonction du temps, :
- du débit instantané au niveau de l'injecteur (A₂),
- du débit moyen au niveau de l'injecteur sur une période d'injection T (B₂),
- du débit instantané mesuré par le débitmètre (C₂)
- et du débit mesuré par le débitmètre et intégré sur une période d'injection T (D₂).

Comme la courbe A₁ de la figure 3, la courbe A₂ est constituée d'une succession d'impulsions rectangulaires de période prédéterminée. Par contre, la courbe C₂, en pointillé, est constituée d'une succession d'impulsions fortement amorties par rapport à la courbe C₁ de la figure 3. De plus, contrairement aux courbes B₁ et C₁, les courbes B₂ et D₂ sont superposées et correspondent à une valeur moyenne unique sensiblement constante et les valeurs de débit de la courbe C₂ fortement amortie sont proches de la valeur moyenne des courbes B₂ et D₂. Ainsi, la présence du filtre passe-bas mécanique permet de mesurer, de manière fiable, le débit moyen, en le rendant sensiblement constant, au niveau du débitmètre sans oscillations marquées.

Le filtre passe-bas mécanique 7, également appelé élément mécanique jouant le rôle d'un filtre passe-bas, est, par exemple, constitué par un amortisseur de pulsation et/ou par une restriction qui est constituée par une portion de la conduite 5 dont la section transversale est inférieure à celle du reste de la conduite 5 de manière à former un étranglement et/ou un raccord destiné à former un volume tampon. Le filtre passe-bas mécanique 7 a, de préférence, une fréquence de coupure faible par rapport à la fréquence de commande de l'injecteur Fᵢₙⱼ, ladite fréquence de coupure étant déterminée par le choix du filtre passe-bas mécanique et par le choix des dimensions du réservoir 2 et de la conduite 5.

L'injection périodique de gouttelettes de précurseur dans l'enceinte est contrôlée par un circuit de commande 4. Le circuit de commande 4 comporte des sorties connectées respectivement au réservoir et à l'injecteur pour contrôler au moins un des paramètres de contrôle choisis parmi la pression P dans le réservoir et plus particulièrement la pression de poussée P_{gaz} dont dépend la pression P dans le réservoir, le temps d'ouverture de l'injecteur tᵢₙₜ, également appelé temps d'injection et la fréquence d'injection Fᵢₙⱼ. Par ailleurs, le circuit de commande 4 comporte une entrée de commande de régulation connectée à la sortie du débitmètre 6 de manière à contrôler au moins un des paramètres de contrôle, c'est-à-dire la pression de poussée P_{gaz} et/ou le temps d'injection tᵢₙⱼ et/ou la fréquence d'injection Fᵢₙⱼ, pour que le débit moyen mesuré Q^{m}ₘₑₛ par le débitmètre 6 n'oscille plus et corresponde à une consigne de débit Q^{m}_{c}(t) qui, elle, peut varier en fonction du temps. Ainsi, le débit moyen d'injection est régulé autour d'une valeur de consigne prédéterminée Q^{m}_{c} à partir de la mesure du débit Q^{m}ₘₑₛ.

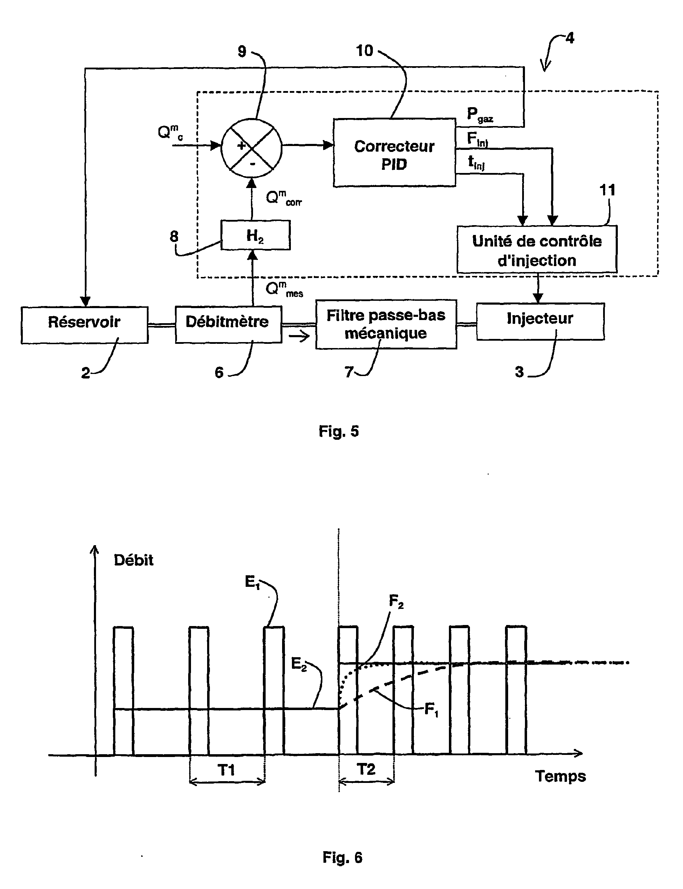

Dans un mode particulier de réalisation représenté à la figure 5, le circuit de commande 4 comporte un circuit de correction 8 connecté à l'entrée de régulation et tenant compte de la fonction de transfert H₁ du filtre passe-bas mécanique 7. Le circuit de correction 8 permet, ainsi, d'obtenir une valeur du débit moyen corrigé Q^{m}_{corr}, égale à H₂×Q^{m}ₘₑₛ, où H₂ est un facteur de correction du circuit de correction 8 dépendant de la fonction de transfert H₁ du filtre passe-bas mécanique. De manière classique, un circuit logique de différence 9 fournit, en sortie, un signal d'erreur entre la valeur de consigne Q^{m}_{c} et la valeur de débit moyen corrigé Q^{m}_{corr}. Le signal d'erreur est alors corrigé par un correcteur 10, par exemple de type PID (Proportionnelle Intégrale Dérivée), de manière à commander au moins un des paramètres de contrôle P_{gaz}, tᵢₙⱼ et Fᵢₙⱼ. Les paramètres tᵢₙⱼ et Fᵢₙⱼ, de commande de l'injecteur 3, agissent alors sur une unité de contrôle d'injection 11 dont une sortie est connectée à l'injecteur 3.

Ainsi, un dispositif tel que celui représenté à la figure 2, avec un filtre passe-bas mécanique 7 et un circuit de commande 4 tel que représenté à la figure 3, permet d'obtenir une injection périodique fiable et reproductible. A titre d'exemple, la figure 6 représente les variations, en fonction du temps, respectivement du débit instantané au niveau de l'injecteur (Courbe E₁), du débit moyen sur une période d'injection au niveau de l'injecteur (Courbe E₂), du débit instantané mesuré Q^{m}ₘₑₛ Par le débitmètre (Courbe F₁) et du débit corrigé Q^{m}_{corr} à partir du débit mesuré par le débitmètre (Courbe F₂), lors d'une modification de la fréquence d'injection Fᵢₙⱼ.

La courbe E₁ est constituée d'une série d'impulsions rectangulaires et dont la période passe de T₁ à T₂ lors de la modification de fréquence. La courbe E₂ est constituée de deux portions de droites invariantes en fonction du temps et décalées l'une par rapport à l'autre lors de la modification Fᵢₙⱼ. On constate, également, que lors de la modification de la fréquence d'injection Fᵢₙⱼ, la variation du débit mesuré par le débitmètre (courbe F₁) est ralentie par rapport au débit moyen sur une période d'injection, au niveau de l'injecteur (Courbe E₂). C'est le filtre passe-bas mécanique qui cause ce ralentissement. La prise en compte de la fonction de transfert H₁ du filtre passe-bas mécanique permet de corriger et donc d'accélérer la variation du débit mesuré par le débitmètre, pour reconstituer mathématiquement, grâce au circuit de correction 8, un débit moyen corrigé (Courbe F₂) se rapprochant du débit moyen au niveau de l'injecteur (Courbe E₂).

Le dispositif d'introduction 1 peut également comporter un circuit de régulation de la pression dans le réservoir 2 et plus particulièrement de la pression de poussée P_{gaz}. Le contrôle précis de la pression de poussée permet, en effet, d'améliorer la stabilité et le contrôle du débit moyen de liquide injecté, quel que soit le type de régulation du débit moyen choisi: aussi bien lorsque l'on souhaite conserver une pression de poussée P_{gaz} constante et faire varier les paramètres de commande de l'injecteur tᵢₙⱼ et Fᵢₙⱼ, que lorsque l'on souhaite faire varier la pression de poussée P_{gaz} et conserver les paramètres de commande de l'injecteur tᵢₙⱼ et Fᵢₙⱼ constants.

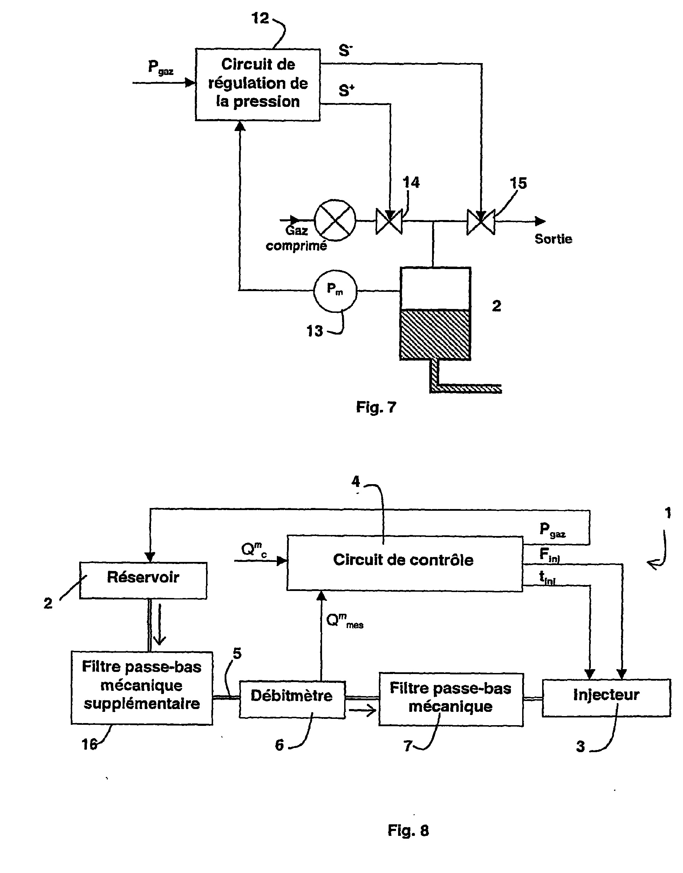

Comme illustré à la figure 7, un circuit de régulation 12 comporte des première et seconde entrées et, de préférence, des première et seconde sorties. La première entrée est connectée à la sortie du circuit de commande 4 associée au réservoir 2, de manière à ce que le paramètre de contrôle P_{gaz} représente la valeur de consigne du circuit de régulation 12 de la pression. La seconde entrée est connectée à un dispositif de mesure 13 de la pression Pₘ dans le réservoir 2 tel qu'un capteur de pression. Les première et seconde sorties du circuit de régulation 12 sont respectivement connectées à une vanne d'entrée 14 et une vanne de sortie 15, de manière à contrôler l'introduction et l'évacuation d'un gaz comprimé dans le réservoir 2. La vanne d'entrée 14, également appelée vanne de pressurisation est, ainsi, ouverte lorsque la pression Pₘ est inférieure à la valeur de consigne P_{gaz}, tandis que la vanne de sortie 15, également appelée vanne d'évacuation, reste fermée. La pression, en amont du débitmètre reste, alors pratiquement constante à la valeur régulée par le dispositif de régulation 12 de pression.

Les vannes 14 et 15 sont, par exemple, des vannes rapides piézoélectriques ou des injecteurs tels que celui utilisé pour l'injection des gouttelettes dans l'enceinte, le temps de commutation de telles vannes étant très rapidement, par exemple inférieur à 1 ms. Les vannes sont, de préférence, commandées en modulation de largeur d'impulsion (PWM ou Pulse Width Modulation) de manière à introduire ou évacuer des quantités faibles et prédéterminées de gaz dans le réservoir 2. Le circuit de régulation de la pression 12 comporte, par exemple, un circuit logique de différence fournissant un signal d'erreur entre la valeur de consigne P_{gaz} et la pression mesurée Pₘ. Le signal d'erreur est ensuite corrigé par deux correcteurs numériques commandant respectivement les vannes d'entrée et de sortie. Les correcteurs numériques calculent, en pratique, le temps d'ouverture des vannes à partir de la différence entre la valeur de consigne de pression et la pression mesurée dans le réservoir.

Les correcteurs numériques dépendent, de préférence, du volume de gaz situé au-dessus du précurseur sous forme liquide contenu dans le réservoir 2, des conductances fluides effectives des vannes d'entrée et de sortie, de la pression du gaz de poussée, de la pression dans le réservoir, de la pression au niveau de la vanne de sortie, de la fréquence d'itération de la boucle de régulation. L'optimisation des correcteurs numériques en fonction de ces différents paramètres permet ainsi de maintenir la pression de poussée du liquide de façon très précise et typiquement à quelques ppm prêts.

Un tel dispositif d'introduction permet d'obtenir une injection discontinue ou en mode pulsé de gouttelettes de précurseur dans l'enceinte, avec un volume de gouttelettes variable, dans les cas suivants :
- lorsque le temps d'ouverture de l'injecteur tᵢₙⱼ est le seul paramètre de commande en permanence modifié pour obtenir un débit moyen de liquide mesuré constant,
- lorsque le temps d'ouverture de l'injecteur tᵢₙⱼ et la fréquence d'injection sont les deux seuls paramètres en permanence modifiés pour obtenir un débit moyen de liquide mesuré constant,
- lorsque la pression dans le réservoir est le seul paramètre en permanence modifié pour obtenir un débit moyen de liquide mesuré constant.

L'invention n'est pas limitée aux modes de réalisation décrits ci-dessus. Ainsi, comme représenté à la figure 8, un dispositif d'introduction tel que représenté à la figure 2 peut également comporter un filtre passe-bas mécanique supplémentaire 16, disposé entre le réservoir 2 et le débitmètre 6. Un tel filtre passe-bas mécanique peut être du même type que le filtre passe-bas mécanique 7 disposé entre le débitmètre 6 et l'injecteur 3.

## Revendications

1. Dispositif d'introduction (1) dans une enceinte d'au moins un précurseur liquide ou en solution d'un élément à déposer sur un support disposé dans l'enceinte, ledit dispositif comportant :
- au moins un réservoir (2) contenant le précurseur,
- des moyens pour maintenir le réservoir (2) à une pression plus élevée que celle de l'enceinte,
- au moins un injecteur (3) connecté au réservoir,
- un circuit de commande (4) comportant des sorties connectées respectivement au réservoir (2) et à l'injecteur (3) pour contrôler ladite pression (P_{gaz}) et/ou le temps d'injection (tᵢₙⱼ) et/ou la fréquence d'injection (Fᵢₙⱼ) de manière à injecter périodiquement, dans l'enceinte des gouttelettes de précurseur,
- un dispositif de mesure de débit moyen (6), disposé entre le réservoir (2) et l'injecteur (3),
- et un filtre passe-bas mécanique (7) ayant une fonction de transfert (H₁) prédéterminée et disposé entre le dispositif de mesure du débit (6) et l'injecteur (3),
et un circuit de commande (4) qui comporte une entrée de régulation connectée à la sortie du dispositif de mesure de débit moyen (6), de manière à contrôler ladite pression (P_{gaz}) et/ou le temps d'injection (tᵢₙ) et/ou la fréquence d'injection (Fᵢₙⱼ) afin de conserver le débit moyen à une valeur de consigne prédéterminée.

2. Dispositif selon la revendication 1, **caractérisé en ce qu'**un filtre passe-bas mécanique supplémentaire (16) est disposé entre le réservoir (2) et le dispositif de mesure du débit (6).

3. Dispositif selon l'une des revendications 1 et 2, **caractérisé en ce que** le filtre passe-bas mécanique (7, 16) est constitué par un amortisseur de pulsation.

4. Dispositif selon l'une des revendications 1 et 2, **caractérisé en ce que** le filtre passe-bas mécanique (7, 16) est une restriction qui est constituée par une portion d'une conduite (5) disposée entre le réservoir (2) et l'injecteur (3), ladite portion ayant une section transversale inférieure à celle du reste de la conduite (5) de manière à former un étranglement.

5. Dispositif selon l'une des revendications 1 et 2, **caractérisé en ce que** le filtre passe-bas mécanique (7, 16) est constitué par un raccord destiné à former un volume tampon.

6. Dispositif selon l'une quelconque des revendications 1 à 5, **caractérisé en ce que** le circuit de commande (4) comporte un circuit de correction (8) connecté à l'entrée de régulation et tenant compte de la fonction de transfert (H₁) du filtre passe-bas mécanique (7).

7. Dispositif selon l'une quelconque des revendications 1 à 6, **caractérisé en ce qu'**il comporte un circuit de régulation de la pression (12) comportant au moins des première et seconde entrées respectivement connectées à la sortie du circuit de commande (4) associée au réservoir (2) et à un dispositif de mesure de la pression (13) dans le réservoir (2).

8. Dispositif selon la revendication 7, **caractérisé en ce que** le circuit de régulation de la pression (12) comporte et au moins des première et seconde sorties, respectivement connectées à une vanne d'entrée (13) et à une vanne de sortie (14), contrôlant respectivement l'introduction et l'évacuation d'un gaz comprimé dans le réservoir (2).

9. Dispositif selon la revendication 8, **caractérisé en ce que** les vannes d'entrée et de sortie (13, 14) sont contrôlées en modulation de largeur d'impulsion.

## Claims

1. Device (1) for injecting into a chamber at least a liquid precursor or a precursor in solution of an element to be deposited on a support arranged in the chamber, said device comprising:
- at least one tank (2) containing the precursor,
- means for keeping the tank (2) at a higher pressure than that of the chamber,
- at least one injector (3) connected to the tank,
- a control circuit (4) comprising outputs respectively connected to the tank (2) and to the injector (3) to control said pressure (P_{gas}) and/or the injection time (tᵢₙⱼ) and/or the injection frequency (Fᵢₙⱼ) in such a way as to periodically inject droplets of precursor into the chamber,
- a device for measuring the mean flowrate (6), arranged between the tank (2) and the injector (3),
- and a mechanical low-pass filter (7) having a predetermined transfer function (H₁) and arranged between the device for measuring the flowrate (6) and the injector (3),
and a control circuit (4) comprising a regulation input connected to the output of the device for measuring the mean flowrate (6) in such a way as to control said pressure (P_{gas}) and/or the injection time (tᵢₙ) and/or the injection frequency (Fᵢₙⱼ) in such a way as to keep the mean flowrate at a predetermined set-point.

2. Device according to claim 1, **characterized in that** an additional mechanical low-pass filter (16) is arranged between the tank (2) and the device for measuring the flowrate (6).

3. Device according to one of the claims 1 and 2, **characterized in that** the mechanical low-pass filter (7, 16) is formed by a pulse damper.

4. Device according to one of the claims 1 and 2, **characterized in that** the mechanical low-pass filter (7, 16) is a restriction that is constituted by a portion of a pipe (5) arranged between the tank (2) and the injector (3), said portion having a smaller transverse cross-section than that of the rest of the pipe (5) in such a way as to form a throttling.

5. Device according to one of the claims 1 and 2, **characterized in that** the mechanical low-pass filter (7, 16) is constituted by a connection designed to form a buffer volume.

6. Device according to one of the claims 1 to 5, **characterized in that** the control circuit (4) comprises a correction circuit (8) connected to the regulation input and taking account of the transfer function (H₁) of the mechanical low-pass filter (7).

7. Device according to one of the claims 1 to 6, **characterized in that** it comprises a pressure regulation circuit (12) comprising at least first and second inputs respectively connected to the output of the control circuit (4) associated with the tank (2) and to a device for measuring the pressure (13) in the tank (2).

8. Device according to claim 7, **characterized in that** the pressure regulation circuit (12) comprises at least first and second outputs respectively connected to an inlet valve (13) and an outlet valve (14) respectively controlling inlet and outlet of a compressed gas to and from the tank (2).

9. Device according to claim 8, **characterized in that** the inlet and outlet valves (13, 14) are controlled in pulse width modulation.

## Patentansprüche

1. Vorrichtung zum Einleiten (1) mindestens eines flüssigen oder in Lösung befindlichen Prekursors eines Elements in eine Kammer, das auf einem Träger abgeschieden werden soll, der sich in der Kammer befindet, welche Vorrichtung umfasst:
- mindestens einen den Prekursor enthaltenden Vorratsbehälter (2),
- Vorrichtungen zum Halten des Vorratsbehälters (2) auf einem Druck, der höher ist als derjenige der Kammer,
- mindestens eine mit dem Vorratsbehälter verbundene Einspritzdüse (3),
- eine Steuerschaltung (4), die Ausgänge umfasst, die jeweils an den Vorratsbehälter (2) und die Einspritzdüse (3) gelegt sind, um den genannten Druck (P_{gaz}) und/oder die Einspritzzeit (tᵢₙⱼ) und/oder die Einspritzfrequenz (Fᵢₙⱼ) zu steuern, um in die Kammer in regelmäßigem Abstand Tröpfchen des Prekursors einzuspritzen,
- eine Vorrichtung zum Messen des mittleren Durchsatzes (6), die zwischen dem Vorratsbehälter (2) und der Einspritzdüse (3) angeordnet ist,
- und einen mechanischen Tiefpassfilter (7), der eine vorbestimmte Übertragungsfunktion (H₁) hat und zwischen der Durchsatzmessvorrichtung (6) und der Einspritzdüse (3) angeordnet ist,
sowie eine Steuerschaltung (4), die einen Regulierungsausgang umfasst, der an den Ausgang der Vorrichtung zum Messen des mittleren Durchsatzes (6) gelegt ist, um den genannten Druck (P_{gaz}) und/oder die Einspritzzeit (tᵢₙⱼ) und/oder die Einspritzfrequenz (Fᵢₙⱼ) zu steuern, um den mittleren Durchsatz auf einem vorbestimmten Sollwert zu halten.

2. Vorrichtung nach Anspruch 1, **dadurch gekennzeichnet, dass** ein zusätzlicher mechanischer Tiefpassfilter (16) zwischen dem Vorratsbehälter (2) und der Durchsatzmessvorrichtung (6) angeordnet ist.

3. Vorrichtung nach einem der Ansprüche 1 und 2, **dadurch gekennzeichnet, dass** der mechanische Tiefpassfilter (7, 16) von einem Schwingungsdämpfer gebildet wird.

4. Vorrichtung nach einem der Ansprüche 1 und 2, **dadurch gekennzeichnet, dass** der mechanische Tiefpassfilter (7, 16) eine Begrenzung ist, die von einem Abschnitt einer Leitung (5) gebildet wird, die zwischen dem Vorratsbehälter (2) und der Einspritzdüse (3) angeordnet ist, wobei der genannte Abschnitt einen Querschnitt hat, der kleiner ist als der der übrigen Leitung (5), um eine Verengung zu bilden.

5. Vorrichtung nach einem der Ansprüche 1 und 2, **dadurch gekennzeichnet, dass** der mechanische Tiefpassfilter (7, 16) von einem Anschlussstück gebildet wird, das dazu bestimmt ist, einen Pufferraum zu bilden.

6. Vorrichtung nach einem der Ansprüche 1 bis 5, **dadurch gekennzeichnet, dass** die Steuerschaltung (4) eine Korrekturschaltung (8) umfasst, die an den Regulierungseingang gelegt ist und die Übertragungsfunktion (H₁) des mechanischen Tiefpassfilters (7) berücksichtigt.

7. Vorrichtung nach einem der Ansprüche 1 bis 6, **dadurch gekennzeichnet, dass** sie eine Schaltung zur Regulierung des Drucks (12) umfasst, die mindestens einen ersten und zweiten Eingang aufweist, die jeweils an den Ausgang der dem Vorratsbehälter (2) zugeordneten Steuerschaltung (4) und an eine Messvorrichtung für den Druck (13) in dem Vorratsbehälter (2) gelegt sind.

8. Vorrichtung nach Anspruch 7, **dadurch gekennzeichnet, dass** die Druckregulierungsschaltung (12) mindestens einen ersten und zweiten Ausgang umfasst, die jeweils an ein Eingangsventil (13) und ein Ausgangsventil (14) gelegt sind, die jeweils das Einleiten und Abführen eines Druckgases in den und aus dem Vorratsbehälter (2) steuern.

9. Vorrichtung nach Anspruch 8, **dadurch gekennzeichnet, dass** Eingangs- und Ausgangsventil (13, 14) impulsbreitenmoduliert gesteuert sind.
